# EUROPÄISCHE PATENTSCHRIFT

(11) **EP 3 363 055 B1**
(45) Veröffentlichungstag und Bekanntmachung des Hinweises auf die Patenterteilung: **14.07.2021**
(21) Anmeldenummer: 15813736.4
(22) Anmeldetag: 09.12.2015
(51) Int. Cl.: H01L 39/16, H02H 9/02, H02M 7/483, H02M 1/32

(54) **HOCHENERGIE-STOSSSTROMBEGRENZER**
HIGH-ENERGY SURGE CURRENT LIMITER
LIMITEUR DU COURANT DE SURCHARGE DE FORTE ÉNERGIE

(43) Veröffentlichungstag der Anmeldung: 22.08.2018
(73) Patentinhaber: Siemens Energy Global GmbH & Co. KG, 81739 München (DE)
(72) Erfinder: ECKEL, Hans-Günter, 18059 Rostock (DE); JUNGHANS, Christoph, 18057 Rostock (DE); SCHMITT, Daniel, 92353 Postbauer-Heng (DE)
(86) Internationale Anmeldenummer: PCT/EP2015/079112
(87) Internationale Veröffentlichungsnummer: WO 2017/097351

(56) Entgegenhaltungen:
- EP-A2- 0 724 274
- WO-A1-2015/155112
- DE-A1-102012 202 513
- DE-B3-102012 218 260
- None

## Beschreibung

Die Erfindung betrifft einen Hochenergie-Stoßstrombegrenzer für einen Spannungszwischenkreis-Stromrichter. Sie betrifft weiter ein spannungsgeführtes Stromrichtermodul und einen Stromrichter.

Stromrichter mit Stromrichtermodulen der genannten Art kommen heute vor allem in der Hochspannungs-Gleichstrom-Übertragung (HGÜ) zur Anwendung, die insbesondere der Energieübertragung mittels Gleichstrom über weite Entfernungen - in der Regel Entfernungen von rund 750 km aufwärts - dient. Hierfür ist zwar ein vergleichsweise hoher technischer Aufwand für hochspannungstaugliche, aufwendige Stromrichter vonnöten, da elektrische Energie in Kraftwerken fast immer durch Synchron-Generatoren als Dreiphasenwechselstrom der Frequenz 50 Hz bzw. 60 Hz erzeugt wird. Allerdings führt die HGÜ ab bestimmten Entfernungen trotz des technischen Aufwands und der zusätzlichen Konverterverluste zu in der Summe geringeren Übertragungsverlusten als die Übertragung mit Dreiphasenwechselstrom.

Hierzu ist es bekannt, Stromrichter zu verwenden, die eine Mehrzahl von in einer Reihe geschalteten spannungsgeführten Stromrichtermodulen (englisch: Voltage-Source Converter, kurz VSC) umfassen (so genannte Multilevel-Stromrichter). Unter einem VSC-Modul wird ein Modul verstanden, das einen Ladungsspeicher in der Art eines Kondensators umfasst, wobei der Spannungswert an den Anschlüssen des Moduls durch entsprechende Ansteuerung von ebenfalls im Modul enthaltenen Halbleiterschaltern mit einer Steuerspannung variiert werden kann. Mit einer Reihe solcher VSC-Module ist es möglich, gestufte Spannungsverläufe zu generieren, deren Stufenhöhe der Nennspannung eines der VSC-Module entspricht, die letztlich die Verbindung zwischen Wechsel- und Gleichstromseite bilden.

Die Verwendung von VSC-Modulen anstatt der bisher üblichen netzgeführten Stromrichter (englisch: Line-commutated Converter, kurz LCC) bietet vielfältige Vorteile, siehe G. Gemmell, J. Dorn, D Retzmann, D. Soerangr, "Prospects of Multilevel VSC Technologies for Power Transmission", in IEEE Transmission and Distribution Conference and Exposition, Chicago, US, April 2008.

Als problematisch hat sich jedoch erwiesen, dass die in den VSC-Modulen verwendeten großen Ladungsspeicher im Fehlerfall (z. B. Schaltversagen eines Halbleiterschalters) schwer zu beherrschen sind, da hierbei ohne zusätzliche Sicherungsmaßnahmen die Energie unkontrolliert und schlagartig freigesetzt wird. Hierbei können ohne Schutzmaßnahmen Stromamplituden von über 1 MA auftreten. Die elektrischen Komponenten des elektrischen Kreises sind im Fehlerfall meist nicht in der Lage, derartige Energien aufzunehmen oder zu kontrollieren. Dies kann zu einer Explosion der Halbleiterbauelemente, Lichtbogenbildung, Verbiegen und Reißen von Stromschienen sowie der Aussendung starker Störfelder führen.

Zur Vermeidung der oben beschriebenen Auswirkungen im Fehlerfall wird daher versucht, den dann auftretenden hohen Stoßstrom durch entsprechende Schaltelemente zu begrenzen. Bisher werden sogenannte RL-Kombinationen (ohmscher Widerstand (R) und Induktivität (L) in Parallelschaltung), entkoppelte Zwischenkreise (ohmscher Widerstand und Induktivität in Serienschaltung) oder schnelle Sicherungen eingesetzt. Kommen keine strombegrenzenden Maßnahmen zum Einsatz, entsteht ein erheblicher Zusatzaufwand, die dann auftretenden mechanischen und elektromagnetischen Auswirkungen des Fehlerfalls beherrschen zu können.

Können im Fehlerfall vergleichsweise hohe Stoßströme entstehen, so müssen die zu deren Begrenzung notwendigen elektrischen Komponenten, wie Widerstand (R) oder Induktivität (L), sehr massiv ausgelegt werden, so dass diese während des Fehlerfalls nicht nachhaltig durch die magnetischen Stromkräfte geschädigt werden. Zur Beherrschung von Kurzschlüssen in hochenergetischen (40-400 kJ) Zwischenkreisen bei Fehlerfallspannungen über 2 kV stehen für parallele RL-Kombinationen keine geeigneten kommerziell erhältlichen Widerstände zur Verfügung, die den auftretenden Belastungen standhalten. Die mechanische Ausgestaltung einer parallelen RL-Kombination ist auch im Hinblick auf eine Wiederverwendbarkeit materialintensiv und großräumig. Die dadurch vergrößerte Leiterschleife bringt zusätzliche Streuinduktivität in den Zwischenkreis ein. Bei seriellen RL-Kombinationen ist die Schutzwirkung im hohen Leistungsbereich zu klein oder die negativen Auswirkungen der hohen Induktivität auf die im Normalbetrieb stattfindende Kommutierung werden zu gravierend. Schnelle Sicherungen sind zwar für die gegebenen Randbedingungen zur Stoßstrombegrenzung geeignet, erfordern aber unter Umständen eine beidseitige Kühlung und sind vergleichsweise kostenintensiv.

Aus der Patentschrift DE 10 2012 218 260 B3 ist ein induktiver Fehlerstrombegrenzer bekannt, der eine normalleitende Primärspulenanordnung mit einer Vielzahl von Windungen und eine supraleitende, kurzgeschlossene Sekundärspulenanordnung umfasst, wobei die Primärspulenanordnung und die Sekundärspulenanordnung zumindest im Wesentlichen koaxial zueinander angeordnet sind.

Die europäische Patentanmeldung EP 0 724 274 A2 offenbart einen supraleitenden induktiven Fehlerstrombegrenzer: Dieser Fehlerstrombegrenzer weist einen Eisenkern mit einer Primärwicklung und einer kurzgeschlossenen supraleitenden Sekundärwicklung auf.

Die deutsche Offenlegungsschrift DE 10 2012 202 513 A1 offenbart eine Vorrichtung zur Strombegrenzung in einer Stromleitung, wobei die Vorrichtung eine mit der Stromleitung in Serie geschaltete Primärspule und eine mit der Primärspule induktiv gekoppelte supraleitende Einrichtung umfasst. Dabei weist die supraleitende Einrichtung einen ersten Abschnitt und einen zweiten Abschnitt auf, wobei der zweite Abschnitt durch ein parallel dazu geschaltetes, normalleitendes Kurzschlusselement überbrückt ist.

Aus der Schrift WO 2015/155112 A1 ist ein modularer Multilevel-Stromrichter bekannt.

Es ist Aufgabe der Erfindung, einen Hochenergie-Stoßstrombegrenzer der eingangs genannten Art anzugeben, welcher in einem Stromrichtermodul einerseits eine zuverlässige Begrenzung des Stoßstromes im Fehlerfall auch bei hohen und höchsten Energien erlaubt, andererseits aber einen vergleichsweise geringen Einfluss auf die Schalttätigkeit des Stromrichtermoduls im Normalbetrieb hat.

Diese Aufgabe wird erfindungsgemäß gelöst durch einen Hochenergie-Stoßstrombegrenzer nach dem Patentanspruch 1. Dabei umfasst der Stoßstrombegrenzer eine Primärwicklung mit zwei elektrischen Anschlüssen und eine mit der Primärwicklung magnetisch gekoppelte Sekundärwicklung, wobei die Sekundärwicklung kurzgeschlossen ist.

Die Erfindung geht dabei von der Überlegung aus, dass zur weiteren Erhöhung der möglichen Energien, bei denen der Stoßstrom zuverlässig begrenzt werden kann, eine Weiterentwicklung bzw. Ertüchtigung der bisherigen Technologie insbesondere der RL-Kombinationen nicht ausreichend erscheint. Statt dessen sollte auf die bekannte Kombination von diskreten Elementen (ohmscher Widerstand und Induktivität) verzichtet werden, und eine Variante favorisiert werden, die einem sekundärseitig kurzgeschlossenen Transformator gleicht. Daher kann auch wie oben geschehen von einer Primärwicklung gesprochen werden, da der eigentliche ohmsche Anteil über eine kurzgeschlossene Sekundärwicklung realisiert wird. Die Primärseite des Transformators ist aktiver Bestandteil des Kommutierungskreises des Stromrichtermoduls, d.h. die Primärseite liegt in Serie mit Energiespeicher (Kondensator) und den Halbleiterschaltern. Im Fehlerfall transformiert die Primärwicklung die aufgrund des steilen Stromanstiegs aufgenommene Spannung in die Sekundärwicklung, welche dabei durch ihren ohmschen Widerstand einen Teil der gespeicherten elektrischen Energie in Wärme umwandelt. Der induktive Anteil der Primärwicklung begrenzt die Stromanstiegsgeschwindigkeit und nimmt einen weiteren Teil der Energie im Feld auf, der bei der folgenden Abmagnetisierung im Widerstand der Sekundärwicklung wiederum in Wärme umgewandelt wird. Die dabei über dem Stoßstrombegrenzer auftretende Gegenspannung begrenzt den Kurzschlussstrom in der Amplitude.

Die Frequenz des Kurzschlussstroms wird durch die im Kurzschlussfall wirksame höhere Induktivität ebenfalls verringert. Dadurch reduziert sich die Aussendung hochfrequenter magnetischer Felder, die benachbarte Baugruppen stören könnten.

In experimentellen Versuchen konnten ca. 90% der insgesamt im Stoßstrombegrenzer umgesetzten Energie in der Sekundärwicklung abgebaut werden. Dabei war es möglich, bis zu 80% der im Zwischenkreis gespeicherten Energie dissipativ im Stoßstrombegrenzer abzubauen.

Im Normalbetrieb übernimmt der Widerstand durch die magnetische Kopplung während der Kommutierung den Laststrom, bis das Feld aufmagnetisiert ist. Die Sekundärwicklung begrenzt wirksam den sonst sehr hohen induktiven Spannungsabfall durch ihre Gegeninduktivität. Nach Abklingen des Schaltvorgangs bzw. nach Aufmagnetisierung des Feldes fließt der Laststrom nur noch durch die Primärwicklung.

Beim Abschalten magnetisiert sich das Feld in die Sekundärwicklung ab, wodurch die induktive Überspannungsspitze stark reduziert wird. In der Sekundärwicklung wird bei jedem Schaltvorgang Energie dissipativ umgesetzt. Die Kühlung der Sekundärwicklung erfolgt großflächig über die Primärwicklung.

Im Kurzschlussfall transformiert die Primärwicklung die aufgrund des steilen Stromanstiegs aufgenommene Spannung in die Sekundärwicklung, welche dabei einen Teil der im Zwischenkreis gespeicherten elektrischen Energie in Wärme umwandelt. Bei der Applikation von Gleichstrom treten nur die Kupferverluste der Primärwicklung in Erscheinung.

Vorteilhafterweise sind bei dem Hochenergie-Stoßstrombegrenzer Primärwicklung und Sekundärwicklung im Wesentlichen zylindermantelförmig ausgebildet und vorteilhafterweise ineinander angeordnet, d.h. Primär- und Sekundärwicklung sind auf gleicher axialer Höhe angeordnet und eine der beiden Wicklungen weist einen geringeren Radius auf, so dass sie innerhalb der anderen Wicklung angeordnet ist. Dies bietet den Vorteil einer vergleichsweise sehr kleinen Streuinduktivität, da Primär- und Sekundärwicklung sehr nah beieinander liegen, und es wird ein einfacher technischer Aufbau ermöglicht, da im Wesentlichen zu einem Zylindermantel gebogene Stromschienen verwendet werden können. Zwischen Primär- und Sekundärwicklung befindet sich dabei eine nicht zwingend durchgängige Isolationsschicht. Bei Auswahl und Dimensionierung der Materialien ist auf die im Fehlerfall auftretende thermische Belastung zu achten.

Die Primärwicklung und die Sekundärwicklung sind punktuell elektrisch verbunden. Hierdurch ist der elektrische Kurzschluss für die Sekundärwicklung über die Primärwicklung realisiert.

Weiterhin ist vorteilhafterweise zwischen parallelen Windungen von Primär- und/oder Sekundärwicklung jeweils eine Isolationslage angeordnet.

Bei dem Hochenergie-Stoßstrombegrenzer sind Primär- und Sekundärwicklung mit einem Spannverband fixiert. Dieser wirkt in radialer Richtung und hält die Lagen flächig kraftschlüssig zusammen. Die Flächenpressung eines derartigen Spannverbandes wirkt den Kräften im Fehlerfall entsprechend entgegen, ohne dass dabei der Stoßstrombegrenzer nachhaltig deformiert oder gar zerstört wird. Es kann ein Effekt gegenseitiger mechanischer Stützung ausgenutzt werden, da die Kraftrichtungen auf Primär- und Sekundärwicklung zeitabhängig entgegengesetzt sein können.

Die elektrischen Anschlüsse des Stoßstrombegrenzers sind dabei vorteilhafterweise am Spannverband angeordnet.

Weiterhin sind Primär- und Sekundärwicklung vorteilhafterweise durch eine Stützkonstruktion mechanisch stabilisiert. Der Stoßstrombegrenzer kann nämlich sowohl einlagig als auch mehrlagig ausgeführt werden, d.h. er kann aus mehreren Primär- und Sekundärwicklungen bestehen, die sich örtlich überlappen und elektrisch miteinander verbunden sein können. Je nach Ausführung ist es dabei erforderlich, zusätzlich eine Stützkonstruktion vorzusehen, die die magnetischen Kräfte, welche auf die Windungen einwirken, aufnehmen und ableiten kann.

In besonders vorteilhafter Ausgestaltung umfasst die Primärwicklung zwei Windungen und die Sekundärwicklung eine Windung, die zwischen den zwei Windungen der Primärwicklung angeordnet und über die Primärwicklung kurzgeschlossen ist. Mit anderen Worten: Die Sekundärwicklung liegt isoliert zwischen den Primärwindungen, wobei der geschlossene Stromkreis der Sekundärwicklung durch einen kurzen überlappenden Kontakt über die Primärwicklung gewährleistet ist. Dies führt zu einem mechanisch besonders geschickten Aufbau, welcher besonders gut für die hohen Belastungen verwendet werden kann und gleichzeitig sehr niederinduktiv ist, wobei keine diskreten Bauteile eingesetzt werden müssen.

In einer ersten vorteilhaften Ausgestaltung ist die Primärwicklung einteilig ausgeführt, d.h. die zwei Windungen sind einteilig auf einer zweimal spiralförmig gewundenen Stromschiene gebildet. Dies verhindert Lichtbögen, die bei einer mehrteiligen Fertigung evtl. auftreten könnten.

In einer alternativen vorteilhaften Ausgestaltung sind die zwei Windungen der Primärwicklung als separate Teile gebildet und berühren einander in einem Überlappungsbereich. In einer derartigen Anordnung ergibt sich eine einfache technische Konstruktion, da die drei Windungen gegeneinander isoliert aufgeschichtet und gemeinsam zum Zylindermantel gebogen werden können.

In einer vorteilhaften Ausgestaltung des Hochenergie-Stoßstrombegrenzers besteht die Sekundärwicklung aus einem Kaltleiter, insbesondere Edelstahl. Das bedeutet, dass der Widerstandswert bei Erhitzung einen PTC-(Positive Temperature Co-efficient-)Charakter aufweist. Dies kann besonders einfach mit der Wahl des Materials für die Sekundärwicklung erfüllt werden, indem insbesondere Edelstahl z.B. V2A verwendet wird. V2A weist einen für Metalllegierungen sehr hohen spezifischen Widerstand auf, so dass über die Materialstärke eine Wärmekapazität erreichbar ist, die die wegzudämpfende/zu dissipierende Energie aufnehmen kann. Die Erwärmung der Sekundärwicklung des Hochenergie-Stoßstrombegrenzers im Fehlerfall ist bei der Materialwahl, z.B. für die Isolierlage, zu berücksichtigen.

Der Hochenergie-Stoßstrombegrenzer ist vorteilhafterweise für eine Energie von mehr als 10 kJ und/oder eine Spannung von mehr als 1 kV und/oder eine Streuinduktivität zwischen Primär- und Sekundärwicklung von weniger als 100nH ausgelegt. Dies ist dem Fachmann durch entsprechende Wahl der Blechstärken der Primär- und Sekundärwicklungen möglich. Gerade in derartigen Energie- und Spannungsbereichen sind herkömmliche RL-Kombinationen nur eingeschränkt verwendbar und der hier beschriebene Hochenergie-Stoßstrombegrenzer von besonderem Vorteil.

Ein spannungsgeführtes Stromrichtermodul mit mindestens einem Leistungshalbleiterventil und einem Ladungsspeicher für einen Stromrichter weist vorteilhafterweise einen solchen Hochenergie-Stoßstrombegrenzer auf, der in Reihe zu dem Leistungshalbleiter und dem Ladungsspeicher angeordnet ist.

Ein Spannungszwischenkreis-Stromrichter umfasst vorteilhafterweise eine Mehrzahl von derartigen, in einer Reihe geschalteten spannungsgeführten Stromrichtermodulen.

Die mit der Erfindung erzielten Vorteile bestehen insbesondere darin, dass durch die Kombination von ohmschem Widerstand und Induktivität über eine magnetische Kopplung ein Hochspannungs-Stoßstrombegrenzer geschaffen wird, der besonders geringe Einflüsse auf normale Schaltvorgänge hat und gleichzeitig besonders hohe Stoßströme im Fehlerfall mitigieren kann, und sich dadurch besonders für den Einsatz in spannungsgeführten Stromrichtermodulen von Multilevel-Stromrichtern eignet. Der oben beschriebene Stoßstrombegrenzer besitzt die Eigenschaft einer sehr kleinen Streuinduktivität, da Primär- und Sekundärwicklung sehr nah beieinander liegen und auch die Stromzuleitung bzw. -ableitung übereinander liegen. Gleichzeitig ist die Begrenzungswirkung auch stromabhängig: je höher der Stoßstrom (Magnetfeld) im Primärkreis wird, desto höher wird auch der induzierte Strom in der Sekundärwicklung. Somit wirkt die Schutzbeschaltung maximal und effizient nur im Falle des Fehlers (z.B. vollständiger Kurzschluss einer Brücke in einem Stromrichtermodul). Bei der Applikation von Gleichstrom treten nur die Kupferverluste der Primärwicklung in Erscheinung.

Die magnetische Kopplung der ohmschen und induktiven Komponenten gewährleistet weiterhin auch eine gute Skalierbarkeit. Die Materialien zum Aufbau sind leicht verfügbar und preisgünstig. Eine aufwändige Einbindung eines pulsfesten Widerstands und der Zukauf spezieller diskreter Bauteile (Widerstand, Sicherung) entfallen. Im Gegensatz zu einer Sicherung ist auch eine Wiederverwendbarkeit gegeben.

Durch den gekonnten mechanischen Ansatz kann auch Bauraum eingespart werden, der wiederum dem Kommutierungskreis zu Gute kommt. Hier liegt auch das Hauptaugenmerk auf einer möglichst klein aufgespannten Fläche, in der Kommutierungsstrom fließt, obwohl auch mit dem beschriebenen Stoßstrombegrenzer wissentlich zusätzliche nH und damit relevante Streuinduktivität eingebaut wird.

Ausführungsbeispiele der Erfindung werden anhand von Zeichnungen näher erläutert. Darin zeigen:
- FIG 1: einen Hochenergie-Stoßstrombegrenzer in einer Ausführungsform mit einer Windung im Querschnitt,
- FIG 2: einen Hochenergie-Stoßstrombegrenzer in einer Ausführungsform mit zwischen zwei Windungen der Primärwicklung angeordneter Sekundärwicklung und zweiteiliger Primärwicklung im Querschnitt,
- FIG 3: einen Hochenergie-Stoßstrombegrenzer in einer Ausführungsform mit zwischen zwei Windungen der Primärwicklung angeordneter Sekundärwicklung und einteiliger Primärwicklung im Querschnitt,
- FIG 4: einen Schaltplan eines spannungsgeführten Stromrichtermoduls mit Darstellung der Anordnung des Hochenergie-Stoßstrombegrenzers,
- FIG 5: einen schematischen Schaltplan eines Multilevel-Stromrichters,
- FIG 6: eine Messung der elektrischen Größen des Stoßstrombegrenzers aus FIG 3 im Falle eines Kurzschlusses, und
- FIG 7: einen Hochenergie-Stoßstrombegrenzer in einer Ausführungsform mit höherer Windungsanzahl im Querschnitt.

Gleiche Teile sind in allen Zeichnungen mit denselben Bezugszeichen versehen.

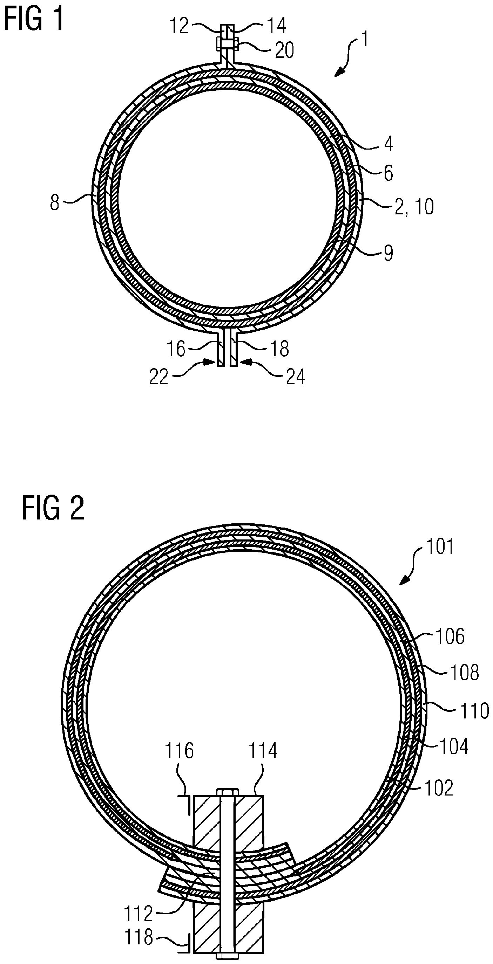

FIG 1 zeigt einen Hochenergie-Stoßstrombegrenzer 1 in einer ersten Ausführungsform im Querschnitt. Der Hochenergie-Stoßstrombegrenzer weist eine im Wesentlichen zylindermantelförmige Geometrie auf. Sein Durchmesser liegt dabei im Bereich von ca. 15-50 cm, seine Höhe bei ca. 5-20 cm (diese Größenordnungen gelten auch für die Ausführungsbeispiele der FIG 2, FIG 3 und FIG 7). Diese Größen sowie die Dicken der im Folgenden beschriebenen Lagen des Zylindermantels sind variabel und vom Fachmann hinsichtlich der gewünschten Auslegung für den fließenden Strom im Betrieb, für die erreichbare Hauptinduktivität und Dämpfung sowie für die auftretende Streuinduktivität zwischen Primär- und Sekundärseite anpassbar.

Die zylindermantelförmige Geometrie des Hochenergie-Stoßstrombegrenzers 1 wird im Ausführungsbeispiel nach der FIG 1 im Wesentlichen durch eine dreilagige Leiterwandung gebildet, die aus einer äußeren Leiterlage 2, einer inneren Leiterlage 4 und einer dazwischen liegenden Isolationslage 6 besteht. Im Inneren der inneren Leiterlage 4 ist weiterhin eine ebenfalls zylindermantelförmige Stützkonstruktion 9 aus einem elektrisch nicht leitfähigen Material angeordnet, die verhindert, dass die innere Leiterlage 4 durch die magnetischen Kräfte nach innen gedrückt wird. Die äußere Leiterlage 2 ist zweiteilig aus spiegelsymmetrischen, jeweils im Querschnitt halbkreisförmigen Teilen 8, 10 aus einem leitenden Material, im Ausführungsbeispiel Kupfer aufgebaut, die an beiden Enden jeweils einen Flansch 12, 14, 16, 18 aufweisen. Auf einer Seite sind die Flansche 12, 14 durch eine Verschraubung 20 verbunden. Auf der gegenüberliegenden Seite sind die Flansche 16, 18 voneinander beabstandet, so dass keine elektrische Verbindung besteht. An beiden Flanschen 16, 18 ist jeweils ein elektrischer Anschluss 22, 24 angeordnet, mit dem der jeweilige Flansch 16, 18 mit einer nicht dargestellten Stromschiene verbindbar ist. Die äußere Leiterlage 2 bildet somit eine Primärwicklung mit einer einzigen Windung.

In einer nicht dargestellten alternativen Ausführungsform können die Flansche 12, 14 mit der Verschraubung 20 auch entfallen und die äußere Leiterlage 2 kann einteilig und im oberen Bereich durchgehend ausgebildet sein.

Innerhalb dieser äußeren Leiterlage 2 ist, durch eine im Querschnitt kreisförmige Isolationslage 6 aus einem Isolator, z.B. Glimmer, Isolierpapier oder glasfaserverstärktem Kunststoff von der äußeren Leiterlage 2 getrennt, die ebenfalls im Querschnitt kreisförmige innere Leiterlage 4 angeordnet. Die innere Leiterlage 4 ist aus einem Leiter gefertigt, im Ausführungsbeispiel aus einem Edelstahl, der einen nicht zu vernachlässigenden ohmschen Widerstand aufweist. Durch die geschlossene Kreisform und die Anordnung innerhalb der Primärwicklung bildet die innere Leiterlage 4 eine kurzgeschlossene Sekundärwicklung, die mit der Primärwicklung magnetisch gekoppelt ist und elektrisch verbunden sein kann.

In anderen Ausführungsformen kann die Lage von Primär- und Sekundärwicklung auch vertauscht sein, d.h. die Primärwicklung ist innen angeordnet.

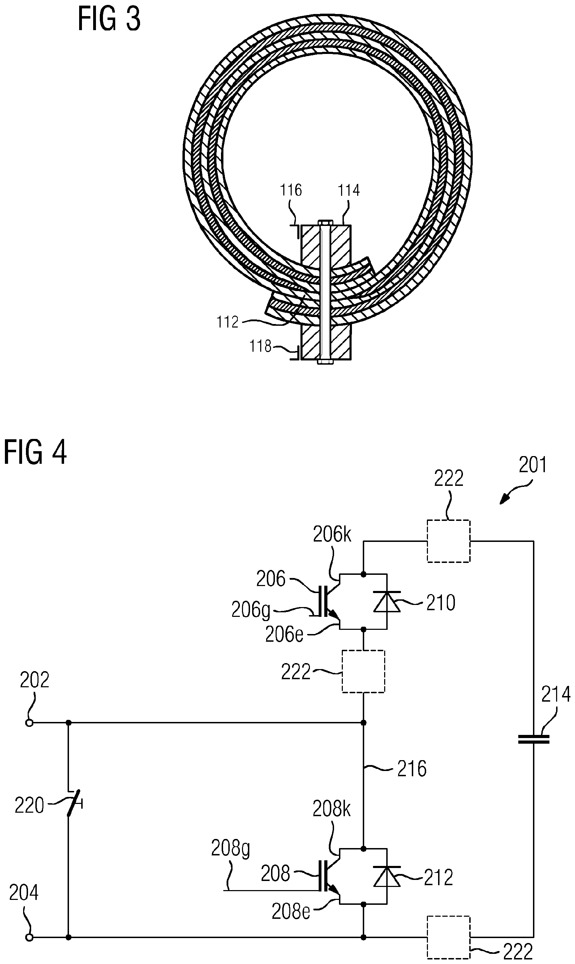

Die Funktion des Hochenergie-Stoßstrombegrenzers 1 wird erläutert, sobald dessen Einsatzbereich und Verschaltung anhand von FIG 3 und FIG 4 im Folgenden erläutert wurden. Zunächst zeigt jedoch FIG 2 eine weitere, verbesserte Ausführungsform eines Hochenergie-Stoßstrombegrenzers 101, die mechanisch fester ist.

Der Hochenergie-Stoßstromtransformator 101 umfasst ebenfalls eine im Wesentlichen zylindermantelförmige Leiterwandung, die jedoch im Querschnitt spiralförmig mit einem Überlapp gestaltet ist. In ihrer Auffaltung ist sie rechteckförmig, weist dabei aber eine in Umfangsrichtung größere Länge auf als der Umfang des Zylindermantels. Die Enden der Leiterwandung bilden dadurch die genannte Überlappung. Im Bereich 112 der Überlappung sind die Lagen 102, 104, 106, 108, 110 durch eine Klemmverbindung 114 verbunden, so dass hier kraftschlüssig ein Spannverband gebildet wird.

Die im Wesentlichen zylinderförmige Leiterwandung umfasst dabei fünf Lagen, nämlich von innen nach außen eine erste Leiterlage 102, eine erste Isolationslage 104, eine zweite Leiterlage 106, eine zweite Isolationslage 108, und eine dritte Leiterlage 110. Im Bereich 112 der Überlappung sind äußeres Ende der zweiten Isolationslage 108 und inneres Ende der ersten Isolationslage 104 verkürzt, so dass dort eine elektrische Verbindung zwischen dem inneren Ende der zweiten Leiterlage 106, dem inneren Ende der dritten Leiterlage 110, dem äußeren Ende der ersten Leiterlage 102 und dem äußeren Ende der zweiten Leiterlage 106 besteht. Elektrische Anschlüsse 116, 118 für die Stromschienen zur Stromzuführung sind mit dem inneren Ende der ersten Leiterlage 102 bzw. mit dem äußeren Ende der dritten Leiterlage 110 verbunden. Die Kontaktierung zu den zuführenden Stromschienen kann alternativ auch nur durch Flächenpressung, Verschraubung oder auch verschweißt erfolgen.

Durch diese Anordnung bildet die erste Leiterlage 102 eine erste Windung der Primärwicklung und die dritte Leiterlage 110 eine zweite Windung der Primärwicklung. Diese Leiterlagen 102, 110 sind aus Kupfer gefertigt. Die zweite Leiterlage 106 ist hingegen aus einem Edelstahl, z.B. V2A gefertigt und bildet die Sekundärwicklung. Der Kurzschluss der Sekundärwicklung ist in den Spannverband eingelegt und erfolgt durch definiertes Kontaktieren der Primärwicklung. Im Bereich 112 des Spannverbandes erfolgt damit der Kurzschluss der Sekundärwicklung über die aus Kupfer gebildete Primärwicklung. Bei sehr dicken Isolationslagen 104, 108 können in diesem Bereich 112 alternativ zusätzliche Kupferlagen eingelegt werden, um die Höhe der Isolationslagen 104, 108 im Bereich 112 der Überlappung auszugleichen. Wird Isolationspapier, z.B. Glimmerpapier verwendet, ist dies bei ausreichender Kraftwirkung der Klemmverbindung 114 aber im in FIG 2 gezeigten Ausführungsbeispiel nicht notwendig. An den Enden und im Außenbereich ist ein Überlappen bzw. genügend Kriechweg für die einzelnen und unterschiedlichen Lagen 102, 104, 106, 108, 110 der Wicklungen vorzusehen.

Eine noch vorteilhaftere Ausführungsform ist in FIG 3 gezeigt. Die dortige Ausführungsform unterscheidet sich von der in FIG 2 lediglich dadurch, dass die Primärwicklung einteilig ausgeführt ist. Es existiert damit kein inneres Ende der zweiten Leiterlage 106 und kein äußeres Ende der ersten Leiterlage 102, sondern diese Leiterlagen 102, 106 gehen im Bereich der Überlappung einteilig ineinander über. Damit wird die Kontaktierung erleichtert und die mechanische Stabilität gegenüber der Ausführungsform in FIG 2 noch einmal erhöht.

Anhand von FIG 4 soll die Verschaltung des Hochenergie-Stoßstrombegrenzers 1, 101 erläutert werden. FIG 4 zeigt den Schaltplan eines Ausführungsbeispiels eines spannungsgeführten Stromrichtermoduls 201 in einer Halbbrückenschaltung, die vergleichsweise einfach aufgebaut ist, dafür aber hinsichtlich ihrer Schaltmöglichkeiten eingeschränkt. Dem Fachmann sind weitere Bauformen von spannungsgeführten Stromrichtermodulen 201 bekannt, wie z.B. Vollbrückenschaltungen oder Clamp-Doppelsubmodule, in denen der Stoßstrombegrenzer 1, 101 ebenso zur Anwendung kommen kann.

Das Stromrichtermodul 201 hat zwei externe Wechselstromanschlüsse 202, 204, mit denen mehrere Stromrichtermodule 201 in Reihe geschaltet werden, wie in FIG 4 noch näher erläutert wird. Das Stromrichtermodul 201 umfasst im Ausführungsbeispiel zwei Halbleiterschalter 206, 208 in Form von Bipolartransistoren mit isolierter Gate-Elektrode (englisch: Insulated-Gate bipolar Transistor, kurz IGBT), denen jeweils eine Freilaufdiode 210, 212 gegenläufig parallel geschaltet ist. Prinzipiell sind aber auch andere Arten von Transistoren verwendbar.

In der FIG 4 und den folgenden Zeichnungen sind die Halbleiterschalter 206, 208 nur als jeweils einzelne IGBTs dargestellt. Selbstverständlich kann dies aber auch nur repräsentativ für mehrere IGBTs stehen, die eine funktionale Einheit bilden, d. h. die z. B. parallel geschaltet sind und deren Gates miteinander verbunden sind oder gemeinsam angesteuert werden.

Die Halbleiterschalter 206, 208 sind mit einem Ladungsspeicher 214 in Form eines Kondensators (Zwischenkreis) als zentrales Element in der Art einer Halbbrücke verschaltet, d. h. die beiden Halbleiterschalter 206, 208 sind in gleicher Richtung seriell geschaltet und bilden mit dem Ladungsspeicher 214 einen Kreis. Die Halbleiterschalter 206, 208 weisen jeweils einen Kollektor 206k, 208k, ein Gate 206g, 208g, und einen Emitter 206e, 208e auf. Der erste Wechselstromanschluss 202 ist mit der Verbindung zwischen Emitter 206e des ersten Halbleiterschalters 206 und Kollektor 208k des zweiten Halbleiterschalters 208 des Kreises verbunden. Der zweite Wechselstromanschluss 204 ist mit der Verbindung zwischen Emitter 208e des zweiten Halbleiterschalters und Ladungsspeicher 214 verbunden. Der Halbleiterschalter 208 ist somit mit seiner Kollektor-Emitter-Strecke in den Strompfad 216 zwischen den beiden Wechselstromanschlüssen 202, 204 geschaltet.

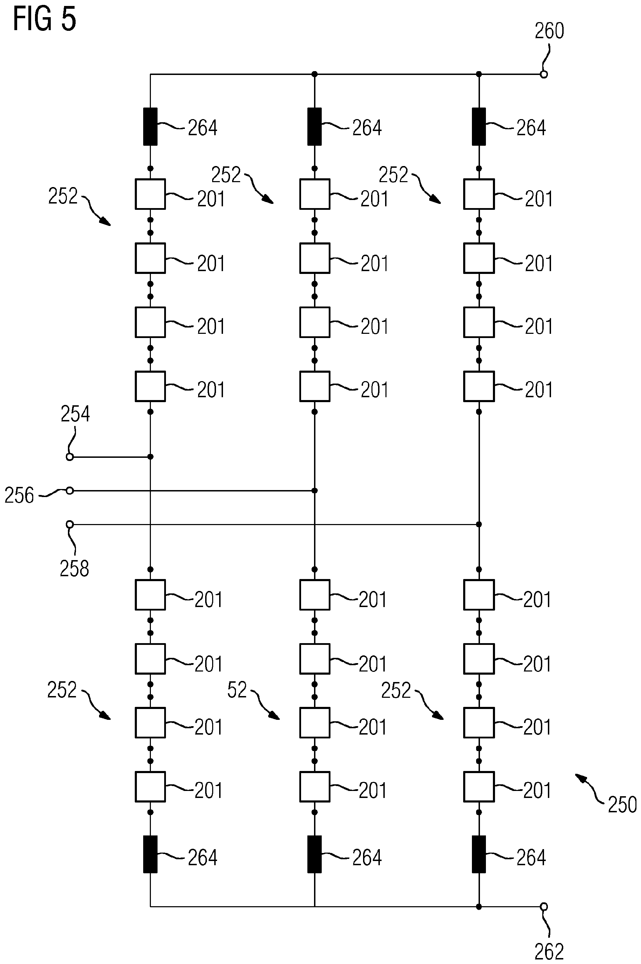

Die Halbleiterschalter 206, 208 sind mittels einer nicht näher dargestellten elektronischen Ansteuerung einzeln ansteuerbar/schaltbar. Die Ansteuerung vermag über externe Steuerimpulse den angeschlossenen IGBT ein oder auszuschalten. In einer Ausführungsform kann hierbei eine baulich realisierte Verriegelung vorhanden sein, die ein gleichzeitiges Schalten beider Halbleiter 206, 208 verhindert. Dadurch kann die am Ladungsspeicher 214 anliegende Spannung U auf die Wechselstromanschlüsse 202, 204 geschaltet werden. Zwischen den Wechselstromanschlüssen 202, 204 liegt demnach je nach Schaltzustand der Halbleiterschalter 202, 204 die Spannung +U oder 0 V an. Jede Stromrichtung ist dabei möglich. Durch die Reihenschaltung mehrerer Stromrichtermodule 201 kann so ein gestufter Spannungsverlauf erzeugt werden, wie anhand von FIG 5 noch erläutert wird.

FIG 4 zeigt zusätzlich noch einen Bypassschalter 220 zwischen den Wechselstromanschlüssen 202, 204, der zur Überbrückung des Stromrichtermoduls 201 im Fehlerfalle dient. Weiterhin sind mögliche Einbauorte 222 für Stoßstrombegrenzer 1, 101 gezeigt, nämlich im Ausführungsbeispiel nach der FIG 4 jeweils in den zwei Zuleitungen zum Ladungsspeicher 214, die üblicherweise als massive Stromschienen ausgeführt sind, und innerhalb der Halbbrücke. Mit anderen Worten: Der Hochenergie-Stoßstrombegrenzer 1, 101 ist zwischen die Halbleiterschalter 206, 208 und den Ladungsspeicher 214 oder zwischen die Halbleiterschalter 206, 208 geschaltet. Hierbei kann der Hochenergie-Stoßstrombegrenzer 1, 101 alternativ auch nur an einem der Einbauorte 222 angeordnet sein.

FIG 5 zeigt ein Ausführungsbeispiel eines Stromrichters 250 in einer schematischen Darstellung. Der Stromrichter 250 weist sechs Leistungshalbleiterventile 252 aufweist, die in einer Brückenschaltung miteinander verbunden sind. Jedes der Leistungshalbleiterventile 252 erstreckt sich zwischen einem der drei Drehstromanschlüsse 254, 256, 258 und einem der zwei Gleichstromanschlüsse 260, 262.

Für jede Phase des Wechselspannungsnetzes ist ein Drehstromanschluss 254, 256, 258 vorgesehen. In dem gezeigten Ausführungsbeispiel ist das Wechselspannungsnetz dreiphasig. Somit weist auch der Stromrichter 250 drei Drehstromanschlüsse 254, 256, 258 auf. Der Stromrichter 250 ist in dem gezeigten Ausführungsbeispiel Teil einer Hochspannungsgleichstromübertragungsanlage und dient zur Verbindung von Wechselspannungsnetzen, um zwischen diesen hohe elektrische Leistungen zu übertragen. An dieser Stelle sei jedoch erwähnt, dass der Stromrichter 250 auch Teil einer so genannten FACTS-Anlage sein kann, die zur Netzstabilisierung oder Sicherung einer gewünschten Spannungsqualität dient. Darüber hinaus ist auch eine Verwendung des Stromrichters 250 in der Antriebstechnik möglich. Jedes der Leistungshalbleiterventile 252 in der FIG 5 ist identisch ausgebildet und umfasst eine Reihenschaltung aus Stromrichtermodulen 201 sowie eine Drossel 264. Diese Stromrichtermodule 201 können wie in FIG 4 dargestellt ausgebildet sein, aber auch als Vollbrückenmodule oder Clamp-Doppelsubmodule.

Wie bereits erläutert erfolgt im Normalbetrieb des Stromrichters 250 eine Angleichung der Spannungswerte an den Drehstromanschlüssen 254, 256, 258 und den Gleichstromanschlüssen 260, 262 durch entsprechende Einstellung der Spannungswerte jedes Leistungshalbleiterventils 252. Dies wird durch entsprechende gesteuerte Schaltvorgänge (sog. Kommutierung) in den einzelnen Stromrichtermodulen 201, d.h. deren Halbleiterschaltern 206, 208 erreicht.

Im Folgenden soll das Verhalten des Hochenergie-Stoßstrombegrenzers 1, 101 in den Stromrichtermodulen 201 erläutert werden: Im Normalbetrieb übernimmt der Widerstand durch die magnetische Kopplung während der Kommutierung den Laststrom, bis das Feld aufmagnetisiert ist. Die Sekundärwicklung begrenzt wirksam den sonst sehr hohen induktiven Spannungsabfall durch ihre Gegeninduktivität. Nach Abklingen des Schaltvorgangs bzw. nach Aufmagnetisierung des Feldes fließt der Laststrom nur noch durch die Primärwicklung.

Beim Abschalten magnetisiert sich das Feld in die Sekundärwicklung ab, wodurch die induktive Überspannungsspitze stark reduziert wird. In der Sekundärwicklung wird bei jedem Schaltvorgang Energie dissipativ umgesetzt. Die Kühlung der Sekundärwicklung erfolgt großflächig über die Primärwicklung.

Im Kurzschlussfall transformiert die Primärwicklung die aufgrund des steilen Stromanstiegs aufgenommene Spannung in die Sekundärwicklung, welche dabei einen Teil der im Zwischenkreis gespeicherten elektrischen Energie in Wärme umwandelt. Der induktive Anteil der Primärwicklung begrenzt die Stromanstiegsgeschwindigkeit und nimmt einen weiteren Teil der Zwischenkreisenergie im Feld auf, der bei der folgenden Abmagnetisierung in der Sekundärwicklung wiederum in Wärme umgewandelt wird. Durch die PTC-Charakteristik des Edelstahls wird dieser Effekt noch verstärkt.

Die dabei über dem dissipativen Stoßstromtransformator auftretende Gegenspannung begrenzt den Kurzschlussstrom in der Amplitude. Die Frequenz des Kurzschlussstroms wird durch die im Kurzschlussfall wirksame höhere Induktivität ebenfalls verringert. Dadurch reduziert sich die Aussendung hochfrequenter magnetischer Felder, die benachbarte Baugruppen stören könnten. In experimentellen Versuchen mit der Ausführungsform nach FIG 1 konnten ca. 90% der insgesamt im Stoßstrombegrenzer umgesetzten Energie in der Sekundärwicklung abgebaut werden.

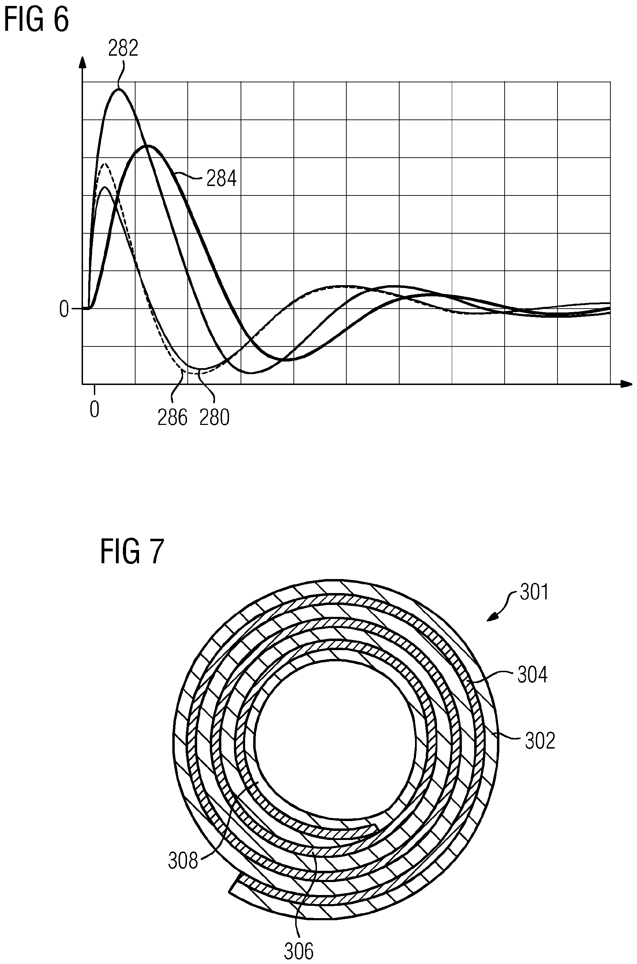

FIG 6 zeigt einen Graphen mit einer Darstellung verschiedener elektrischer Größen des Stoßstrombegrenzers 101 in der Ausführungsform gemäß FIG 2/3 bei Anschluss an einen Ladungsspeicher mit folgendem Kurzschluss, aufgetragen gegen die Zeit, ermittelt anhand einer Messung. Der Graph ist rasterförmig unterteilt, für Abszisse und Ordinate sind jeweils nur die Nulllinien eingezeichnet. Für die Abszisse bezeichnet der Nullpunkt den Zeitpunkt des Kurzschlusses, eine Unterteilung des Rasters entspricht 100 µs. Es sind insgesamt vier verschiedene Größen dargestellt, nämlich
- die Spannung über den Stoßstrombegrenzer 101 in Kurve 280, wobei eine Unterteilung des Rasters 1 kV entspricht,
- der Gesamtstrom durch die Primärwicklung in Kurve 282, wobei eine Unterteilung des Rasters 100kA entspricht,
- der induktive Anteil des Gesamtstroms in Kurve 284, wobei eine Unterteilung des Rasters ebenfalls 100 kA entspricht, und
- der Strom durch die Sekundärwicklung in Kurve 286, wobei eine Unterteilung des Rasters 200kA entspricht.
Der Ladungsspeicher kann eine Startspannung zwischen 1 bis 6 kV und eine Kapazität von zwischen 2 bis 20 mF aufweisen. Die Temperaturerhöhung der Sekundärwicklung durch die umgewandelte Energie beträgt etwa 200 K.

Die Messung zeigt, dass der maximale Strom des vollständigen Brückenkurzschlusses auf ca. 580 kA reduziert werden kann. Ohne Begrenzungsmechanismus würde ca. das Doppelte an Brückenkurzschlussstrom zu Stande kommen, was auch eine bis zu vier Mal größere Kraftwirkung aufgrund der induzierten Magnetfelder zu Folge hätte. Zusätzlich sei darauf hingewiesen, dass bei der Verwendung der in FIG 4 gezeigten Halbleiterschalter 206, 208 in Form von IGBTs eine noch weiter verbesserte Funktion zu erwarten ist: Werden im Experiment Thyristoren als Zünder verwendet, so leiten diese beim Durchlegieren besonders gut. Im kommerziellen Einsatz einer Halb- bzw. Vollbrückenschaltung bilden IGBTs bei vollständigen Brückenkurzschlüssen aber sogar noch eine Gegenspannung aus. Die Gegenspannung wird durch den entstehenden Lichtbogen hervorgerufen und wirkt zusätzlich strombegrenzend.

FIG 7 zeigt abschließend ein weiteres Ausführungsbeispiel eines Hochenergie-Stoßstrombegrenzers 301, ebenfalls im Querschnitt. Dieses geht von der Überlegung aus, dass die Anzahl der Windungen der Primärwicklung prinzipiell nicht begrenzt ist. In der Ausführungsform gemäß FIG 7 umfasst die Primärwicklung eine äußere Leiterlage 302 und eine im Inneren anschließende Isolationslage 304, die gemeinsam in der Art einer zweigängigen Spirale in insgesamt drei Windungen aufgerollt ist, wobei sich auch hier wieder ein Bereich 306 einer Überlappung ergibt. Die Sekundärwicklung ist in Form einer Leiterlage 308 aus Edelstahl im Innenraum im Querschnitt im Wesentlichen kreisförmig an die innerste Isolationslage 304 anschließend angeordnet.

Bei der in FIG 7 gezeigten Ausführungsform mit drei Wicklungen ist gemäß einer Simulation funktionsfähig, es gestaltet es sich jedoch schwierig, die Sekundärwicklung gekonnt anzuordnen. Vorteile bezüglich höherer Begrenzung des Fehlerstromes sind zudem nicht erkennbar und auch die mechanische und großtechnische Herstellbarkeit ist begrenzt möglich bzw. nicht kostengünstig. Zudem steigt bei einer größeren Anzahl von Windungen die Streuinduktivität.

### Bezugszeichenliste

- 1: Hochenergie-Stoßstrombegrenzer
- 2: äußere Leiterlage
- 4: innere Leiterlage
- 5: Stützkonstruktion
- 6: Isolationslage
- 8, 10: Teil
- 12, 14:
- 16, 18: Flansch
- 20: Verschraubung
- 22, 24: elektrischer Anschluss
- 101: Hochenergie-Stoßstrombegrenzer
- 102: erste Leiterlage
- 104: erste Isolationslage
- 106: zweite Leiterlage
- 108: zweite Isolationslage
- 110: dritte Leiterlage
- 112: Bereich
- 114: Klemmverbindung
- 116, 118: elektrischer Anschluss
- 201: Spannungsgeführtes Stromrichtermodul
- 202, 204: Wechselstromanschluss
- 206, 208: Halbleiterschalter
- 206e, 208e: Emitter
- 206g, 208g: Gate
- 206k, 208k: Kollektor
- 210, 212: Freilaufdiode
- 214: Ladungsspeicher
- 216: Strompfad
- 220: Bypassschalter
- 222: Einbauort
- 250: Stromrichter
- 252: Leistungshalbleiterventil
- 254, 256, 258: Drehstromanschluss
- 260, 262: Gleichstromanschluss
- 264: Drossel
- 280, 282, 284, 286: Kurve
- 301: Hochenergie-Stoßstrombegrenzer
- 302: Leiterlage
- 304: Isolationslage
- 306: Bereich
- 308: Leiterlage

## Patentansprüche

1. Hochenergie-Stoßstrombegrenzer (101) für einen Spannungszwischenkreis-Stromrichter, umfassend eine Primärwicklung (102, 110) mit zwei elektrischen Anschlüssen (116, 118) und eine mit der Primärwicklung magnetisch gekoppelte Sekundärwicklung (106), wobei die Sekundärwicklung kurzgeschlossen ist,
**dadurch gekennzeichnet, dass**
die Primärwicklung und die Sekundärwicklung punktuell elektrisch verbunden sind, wodurch der elektrische Kurzschluss für die Sekundärwicklung über die Primärwicklung realisiert ist, und
die Primär- und die Sekundärwicklung mit einem Spannverband fixiert sind.

2. Hochenergie-Stoßstrombegrenzer nach Anspruch 1, bei dem Primärwicklung und Sekundärwicklung im Wesentlichen zylindermantelförmig ausgebildet sind.

3. Hochenergie-Stoßstrombegrenzer nach Anspruch 2, bei dem Primärwicklung und Sekundärwicklung ineinander angeordnet sind.

4. Hochenergie-Stoßstrombegrenzer nach einem der vorhergehenden Ansprüche, bei dem zwischen parallelen Windungen von Primär- und/oder Sekundärwicklung jeweils eine Isolationslage (104, 108) angeordnet ist.

5. Hochenergie-Stoßstrombegrenzer nach einem der vorhergehenden Ansprüche, bei dem die elektrischen Anschlüsse (116, 118) am Spannverband angeordnet sind.

6. Hochenergie-Stoßstrombegrenzer nach einem der vorhergehenden Ansprüche, bei dem Primär- und Sekundärwicklung durch eine Stützkonstruktion (9) mechanisch stabilisiert sind.

7. Hochenergie-Stoßstrombegrenzer nach einem der vorhergehenden Ansprüche, bei dem die Primärwicklung zwei Windungen (102, 110) umfasst und die Sekundärwicklung eine Windung (106) umfasst, die in radialer Richtung zwischen den zwei Windungen (102, 110) der Primärwicklung angeordnet und über die Primärwicklung kurzgeschlossen ist.

8. Hochenergie-Stoßstrombegrenzer nach Anspruch 7, bei dem die Primärwicklung einteilig ausgeführt ist.

9. Hochenergie-Stoßstrombegrenzer nach Anspruch 7, bei dem die zwei Windungen (102, 110) der Primärwicklung als separate Teile gebildet sind und in einem Überlappungsbereich (112) einander berühren.

10. Hochenergie-Stoßstrombegrenzer nach einem der vorhergehenden Ansprüche, bei dem die Sekundärwicklung aus einem Kaltleiter besteht.

11. Hochenergie-Stoßstrombegrenzer nach Anspruch 10, bei dem die Sekundärwicklung aus Edelstahl besteht.

12. Hochenergie-Stoßstrombegrenzer nach einem der vorhergehenden Ansprüche, ausgelegt für eine Energie von mehr als 10 kJ und/oder eine Spannung von mehr als 1 kV und/oder eine Streuinduktivität zwischen Primär- und Sekundärwicklung von weniger als 100nH.

13. Spannungsgeführtes Stromrichtermodul (201) mit mindestens einem Leistungshalbleiterventil und einem Ladungsspeicher (214), sowie mit einem Hochenergie-Stoßstrombegrenzer (101) nach einem der vorhergehenden Ansprüche, der in Reihe zu dem Leistungshalbleiter und dem Ladungsspeicher angeordnet ist.

14. Spannungszwischenkreis-Stromrichter (250), umfassend eine Mehrzahl von in einer Reihe geschalteten spannungsgeführten Stromrichtermodulen (201) nach Anspruch 13.

## Claims

1. High-energy surge current limiter (101) for a voltage intermediate circuit converter, comprising a primary winding (102, 110) having two electrical terminals (116, 118) and a secondary winding (106) magnetically coupled to the primary winding, wherein the secondary winding is short-circuited,
**characterized in that**
the primary winding and the secondary winding are electrically connected at points, whereby the electrical short circuit for the secondary winding is realized by way of the primary winding, and
the primary and the secondary winding are fixed to a tensioning brace.

2. High-energy surge current limiter according to Claim 1, in which the primary winding and the secondary winding are substantially in the form of a surface of a cylinder.

3. High-energy surge current limiter according to Claim 2, in which the primary winding and the secondary winding are arranged in one another.

4. High-energy surge current limiter according to one of the preceding claims, in which in each case an insulation layer (104, 108) is arranged between parallel turns of the primary and/or secondary winding.

5. High-energy surge current limiter according to one of the preceding claims, in which the electrical terminals (116, 118) are arranged on the tensioning brace.

6. High-energy surge current limiter according to one of the preceding claims, in which the primary and secondary winding are mechanically stabilized by a supporting structure (9).

7. High-energy surge current limiter according to one of the preceding claims, in which the primary winding comprises two turns (102, 110) and the secondary winding comprises one turn (106), which is arranged in the radial direction between the two turns (102, 110) of the primary winding and is short-circuited by way of the primary winding.

8. High-energy surge current limiter according to Claim 7, in which the primary winding is embodied in one piece.

9. High-energy surge current limiter according to Claim 7, in which the two turns (102, 110) of the primary winding are formed as separate parts and contact one another in an overlap region (112).

10. High-energy surge current limiter according to one of the preceding claims, in which the secondary winding consists of a PTC thermistor.

11. High-energy surge current limiter according to Claim 10, in which the secondary winding consists of stainless steel.

12. High-energy surge current limiter according to one of the preceding claims, designed for an energy of more than 10 kJ and/or a voltage of more than 1 kV and/or a stray inductance between the primary and secondary winding of less than 100 nH.

13. Voltage source converter module (201) having at least one power semiconductor valve and a charge store (214), and having a high-energy surge current limiter (101) according to one of the preceding claims, which is arranged in series with the power semiconductor and the charge store.

14. Voltage intermediate circuit converter (250), comprising a plurality of voltage source converter modules (201) according to Claim 13 connected in series.

## Revendications

1. Limiteur (101) de courant de surcharge à haute énergie d'un onduleur à circuit intermédiaire de tension, comprenant un enroulement (102, 110) primaire ayant deux bornes (116, 118) électriques et un enroulement (106) secondaire couplé magnétiquement à l'enroulement primaire, l'enroulement secondaire étant court-circuité
**caractérisé en ce que**
l'enroulement primaire et l'enroulement secondaire sont reliés électriquement de manière ponctuelle grâce à quoi le court-circuit électrique de l'enroulement secondaire est réalisé par l'intermédiaire de l'enroulement primaire et
l'enroulement primaire et l'enroulement secondaire sont immobilisés par une attache de serrage.

2. Limiteur de courant de surcharge à haute énergie suivant la revendication 1, dans lequel l'enroulement primaire et l'enroulement secondaire sont constitués en étant sensiblement en forme d'enveloppe cylindrique.

3. Limiteur de courant de surcharge à haute énergie suivant la revendication 2, dans lequel l'enroulement primaire et l'enroulement secondaire sont disposés l'un dans l'autre.

4. Limiteur de courant de surcharge à haute énergie suivant l'une des revendications précédentes, dans lequel respectivement une couche (104, 108) isolante est disposée entre des spires parallèles de l'enroulement primaire et/ou de l'enroulement secondaire.

5. Limiteur de courant de surcharge à haute énergie suivant l'une des revendications précédentes, dans lequel les bornes (116, 118) électriques sont disposées sur l'attache de serrage.

6. Limiteur de courant de surcharge à haute énergie suivant l'une des revendications précédentes, dans lequel l'enroulement primaire et l'enroulement secondaire sont stabilisés mécaniquement par une construction (9) d'appui.

7. Limiteur de courant de surcharge à haute énergie suivant l'une des revendications précédentes, dans lequel l'enroulement primaire comprend deux spires (102, 110) et l'enroulement secondaire comprend une spire (106), qui est disposée dans la direction radiale entre les deux spires (102, 110) de l'enroulement primaire et qui est court-circuitée par l'intermédiaire de l'enroulement primaire.

8. Limiteur de courant de surcharge à haute énergie suivant la revendication 7, dans lequel l'enroulement primaire est réalisé en une pièce.

9. Limiteur de courant de surcharge à haute énergie suivant la revendication 7, dans lequel les deux spires (102, 110) de l'enroulement primaire sont constituées sous la forme de parties distinctes et se touchent l'une l'autre dans une région (112) de chevauchement.

10. Limiteur de courant de surcharge à haute énergie suivant l'une des revendications précédentes, dans lequel l'enroulement secondaire est en une thermistance.

11. Limiteur de courant de surcharge à haute énergie suivant la revendication 10, dans lequel l'enroulement secondaire est en acier fin.

12. Limiteur de courant de surcharge à haute énergie suivant l'une des revendications précédentes, conçu pour une énergie de plus de 10 kJ et/ou une tension de plus de 1kV et/ou une inductance de fuite entre l'enroulement primaire et l'enroulement secondaire de moins de 100 nH.

13. Module (201) d'onduleur sous tension, comprenant au moins une soupape à semi-conducteur de puissance et un accumulateur (214) de charge, ainsi que comprenant un limiteur (101) de courant de surcharge à haute énergie suivant l'une des revendications précédentes, qui est monté en série avec le semi-conducteur de puissance et l'accumulateur de charge.

14. Onduleur (250) à circuit intermédiaire de tension, comprenant une pluralité de modules (201) d'onduleur sous tension suivant la revendication (13) montés en série.
